# EUROPEAN PATENT APPLICATION

(11) **EP 0 821 415 A2**
(43) Date of publication of application: **28.01.1998**
(21) Application number: 97305657.5
(22) Date of filing: 28.07.1997
(51) Int. Cl.: H01L 27/115, H01L 21/3205

(54) **A capacitor and method of manufacture thereof**

(30) Priority: 26.07.1996 JP 215467/96
(71) Applicant: TEXAS INSTRUMENTS INC., Dallas, Texas 75243 (US)
(72) Inventor: Fukuda, Yukio, Naka-gun, Ibaraki 319-11 (JP); Aoki, Katsuhiro, Tsuchiura-shi, Ibaraki 300 (JP); Numata, Ken, Plano, Texas 75093 (US); Nishimura, Akitoshi, Plano, Texas 75024 (US)
(74) Representative: Williams, Janice

(57) **Abstract**

The purpose of this invention is to provide a ferroelectric capacitor and a ferroelectric memory device, which: can perform stable operation without causing a resistivity change that is considered to be caused due to the leakage current and the oxygen diffusion; in which it is difficult for dielectric fatigue to be caused in the ferroelectric capacitor, even by repeated inversions; and in which long life and high reliability can be maintained; and to provide their manufacturing method. The constitution of this invention includes a ferroelectric capacitor CAP which has Ir lower electrode (13), PZT thin film (14), and Ir upper electrode (15) and in which crystal grain layers (14a,14b,and 14c) constituted by assembling crystal grains (50a,50b,and 50c) by means of grain boundaries (51a,51b, and 51c) are laminated by means of grain boundaries (52A and 52B) along the surface of the Ir electrode (13), so that the ferroelectric film (14) is formed. A method for manufacturing the ferroelectric capacitor CAP, which meets all of the important conditions of 1) selection of an optimum electrode substance such as Ir; 2) control of crystal growth direction by means of TiOₓ nucleus attachment and a surplus of Pb; and 3) optimum annealing temperature for eliminating surface precipitates; and which deposits a titanium oxide, forms a ferroelectric film material layer containing a surplus of lead on it, heats it at a temperature at which the surface precipitates are substantially lost, and laminates each crystal grain layer (14a,14b, and 14c) by repeating the above processes.

## Description

### FIELD OF THE INVENTION

The present invention pertains to a capacitor, and more particularly for example to a ferroelectric capacitor having a lead zirconate titanate (PZT) film. The invention also extends to a ferroelectric memory device, in particular for example, a non-volatile semiconductor memory using a ferroelectric capacitor having a PZT film.

### BACKGROUND OF THE INVENTION

A non-volatile memory element, that is, a ferroelectric RAM (Ferroelectric Random Access Memory), which is a non-volatile memory called a FRAM, with a simple structure using the residual polarization characteristic, can be manufactured by forming a capacitor using PZT, which is a ferroelectric substance, as a dielectric film.

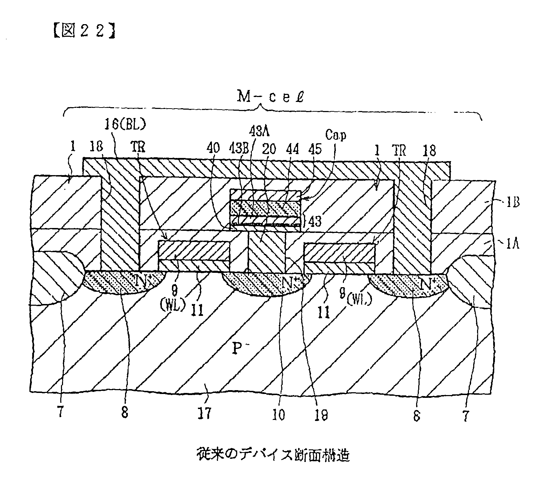

Such a FRAM has already been partially put to practical use, and the PZT capacitor is constituted as shown in FIG. 22. The memory cell is a CUB (Cell Under Bitline) type.

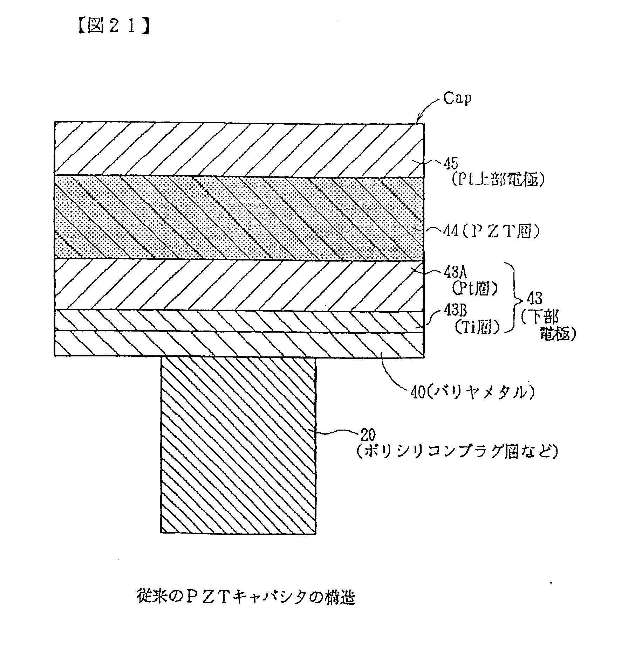

In a conventional PZT capacitor Cap shown in FIG. 21, as a stacked cell capacitor, a Pt/Ti structure, in which a Pt layer 43A is laminated on a Ti adhesion layer 43B, is generally used as a lower electrode 43, and a PZT thin film 44 is formed on it by a sol-gel method, sputtering method, or CVD (Chemical Vapor Deposition) method. Furthermore, Pt is used as an upper electrode 45. Also, a barrier layer 40 of TiN or the like is provided under the lower electrode 43 and connected to the silicon substrate side by means of a polysilicon layer (plug) 20 deposited in a contact hole 19 of an insulation layer 1 (a laminate of 1A and 1B).

In FIG. 22, the memory cell of a FRAM having the above-mentioned PZT capacitor Cap is explained. For example, an element region divided by a field oxide film 7 is formed on one principal face of a P⁻ type silicon substrate 17. Here, a memory cell M-cel, consisting of: transfer gate TR consisting of a MOS transistor; and a capacitor Cap, is provided.

In the transfer gate TR, for example, a N⁺ type source region 10 and a N⁺ type drain region 8 are respectively formed by impurity diffusion, and a word line 9 (WL) is formed by means of a gate oxide film 11 between these two regions. A bit line 16 (BL) is connected to the drain region 8 by means of a contact hole 18 of an insulation layer 1 such as SiO₂.

The capacitor Cap is a stack type, and a polysilicon layer 20 is connected to the source region 10 by means of the contact hole 19 of the insulation layer 1A. Furthermore, the above-mentioned barrier layer 40 and lower electrode 43 are laminated on it, and the PZT ferroelectric film 44 and the upper electrode 45 are sequentially laminated on the lower electrode.

Also, the ferroelectric film 44, which constitutes the capacitor Cap, is composed of PZT, that is, Pb(Zr, Ti)O₃ film formed by the sol-gel method using a raw material solution. Also, the lower electrode 43 is constituted by attaching the Pt layer 43A to the Ti layer 43B, and the upper electrode 45 in contact with the ferroelectric film 44 is composed of Pt.

However, in the above-mentioned conventional FRAM, since the PZT thin film used as a dielectric film to constitute the capacitor is generally composed of a polycrystal, compared with amorphous SiO₂ (silicon oxide) and SiN (silicon nitride) being in the current LSI (large-scale integrated circuit device), leakage current and oxygen hole diffusion easily occur by means of the grain boundaries between crystal grains, and these are considered to be the cause of the problems of deterioration of the resistivity and a reduction in resistance.

Also, in the above-mentioned conventional FRAM, when the PZT capacitor Cap operates, a phenomenon called "dielectric fatigue" in which the polarization characteristic is markedly lowered, easily occurs due to repetition of inversion (that is, a dielectric polarization inversion occurring each time data are written or read out). This is a phenomenon which is a problem in the development of an actual device, and the residual polarization density is sometimes deteriorated by an inversion of approximately 10⁶ times and reduced to 1/2 or less of the initial value. For this reason, it was difficult to develop a device with high reliability with respect to repeated reading and writing.

### SUMMARY OF THE INVENTION

Respective aspects of the present invention are set forth in claims 1 and 5.

Embodiments of the present invention provide a ferroelectric capacitor and a ferroelectric memory device, and their manufacturing method in which: a stable operation without causing a resistivity change, that is considered to result from leakage current and oxygen diffusion can be achieved; it is difficult for dielectric fatigue to occur in the ferroelectric capacitor, even by repeated inversion; and long life and high reliability can be maintained.

An embodiment of the present invention pertains to a ferroelectric capacitor that has a first electrode made of a metal which is easily oxidized, a ferroelectric film on the first electrode, and a second electrode on the ferroelectric film, and in which multiple crystal grain layers constituted by assembling crystal grains by means of the grain boundaries are laminated by means of the grain boundaries along the surface of the above-mentioned first electrode, so that the above-mentioned ferroelectric film is formed.

In a ferroelectric capacitor embodying the invention, although the above-mentioned crystal grain layer is an assembly of crystal grains by means of the grain boundaries, since the grain boundaries exist along (preferably, nearly parallel with) the surface of the first electrode between the multiple crystal grain layers. The latter grain boundaries become obstacles to conductive electrons, a cause of leakage current, and oxygen hole diffusion considered to be a cause of resistivity deterioration. Therefore, the penetration of the conductive electrons and the oxygen holes from the grain boundaries of the lower crystal grain layer into the grain boundaries of the upper crystal grain layer can be effectively suppressed. Therefore, leakage current and resistivity change can be sufficiently prevented, so that those characteristics are markedly improved.

Also, the present invention provides a method for manufacturing a ferroelectric capacitor. In manufacturing a ferroelectric capacitor which has a first electrode made of a metal that is easily oxidized, a ferroelectric film on the first electrode, and a second electrode on the ferroelectric film, and in which multiple crystal grain layers constituted by assembling crystal grains by means of the grain boundaries are laminated by means of the grain boundaries along the surface of the above-mentioned first electrode, so that the above-mentioned ferroelectric film is formed. In an embodiment the method has: a first process for forming the above-mentioned first electrode; a second process for depositing an oxide (in particular, titanium oxide: same hereinafter) of at least one kind of element of the constituent elements of the above-mentioned ferroelectric film on the first electrode; a third process for forming a ferroelectric film material layer containing a surplus of a specified constituent element (in particular, lead: same hereinafter) of the above-mentioned ferroelectric film on the above-mentioned first electrode on which the oxide is deposited, a fourth process for forming a lower layer of the above-mentioned crystal grain layer by heating at a temperature at which surface precipitates (in particular, a structure transitional layer which will be explained later) mainly composed of the above-mentioned specified constituent element are substantially lost; a fifth process for depositing an oxide of at least one kind of element of the constituent elements of the above-mentioned ferroelectric film on the lower crystal grain layer; a sixth process for forming a ferroelectric film material layer containing a surplus of a specified constituent element of the above-mentioned ferroelectric film on the above-mentioned lower crystal grain layer on which the oxide is deposited; and a seventh process for forming an upper layer of the above-mentioned crystal grain layer by heating at a temperature at which surface precipitates mainly composed of the above-mentioned specified constituent element are substantially lost.

The inventors made repeated investigations, in particular with regard to a new manufacturing method of a PZT capacitor to solve the problems of the above-mentioned dielectric fatigue. As a result, it was discovered that in forming a PZT thin film by a sol-gel method, 3 items: (1) selection of an optimum electrode substance (corresponding to the above-mentioned first process); (2) control of crystal growth direction (PZT crystal structure) (corresponding to the above-mentioned first process, third process, fifth process, and sixth process); (3) optimum annealing temperature (corresponding to the above-mentioned fourth process and seventh process), are important, and that a PZT capacitor without dielectric fatigue could be manufactured only when all of these conditions were met. Furthermore, by a combination of processes which met these 3 conditions, a ferroelectric capacitor embodying the invention, which has a unique film structure and with which it is difficult for leakage current, etc., to occur, could be manufactured, achieving the manufacturing method of the ferroelectric capacitor embodying the present invention.

In addition, the present invention provides by means of the above-mentioned or the following ferroelectric capacitor and its manufacturing method a ferroelectric memory cell and its manufacturing method, which manufactures a ferroelectric capacitor in a memory cell.

In the ferroelectric capacitor and the ferroelectric memory device of the present invention, specifically, in each of the above-mentioned multiple crystal grain layers, it is desirable that the grain boundaries extending from the first electrode to the second electrode exist at different positions between the above-mentioned crystal grain layers, and that the grain boundaries between the above-mentioned multiple crystal grain layers exist continuously along the surface of the above-mentioned first electrode.

Also, it is desirable that both the above-mentioned first electrode and second electrode be made of a metal such as iridium which is easily oxidized, and that the ferroelectric film be made of lead zirconate titanate.

In the method for manufacturing the ferroelectric capacitor and the ferroelectric memory device of the present invention, each process corresponding to the above-mentioned fifth, sixth, and seventh processes can be applied (or repeated) by just the required number of times. In other words, 2 layers or more (for example, three layers) of the above-mentioned crystal grain layers can be laminated.

Also, specifically, in manufacturing a ferroelectric capacitor in which the first electrode and the second electrode are respectively made of a metal that is easily oxidized and in which the ferroelectric film is made of lead zirconate titanate: in the above-mentioned second process and the fifth process a titanium oxide is respectively deposited; in the above-mentioned third process and the sixth process and amorphous layer of lead zirconate titanate lead containing a surplus of lead is respectively formed; in the above-mentioned fourth process and the seventh process, annealing for forming a crystal layer of lead zirconate titanate is respectively carried out at a temperature at which surface precipitates mainly composed of a surplus of lead are substantially lost, and/or post-annealing of the above-mentioned crystal layer is respectively carried out. Thereby, the above-mentioned second electrode is formed on the crystal layer.

In this case, it is desirable that the lead content of the amorphous layer of the lead zirconate titanate be (1.02-1.50) times, at an atomic number ratio, of the total amount of zirconium, and titanium and that the annealing and post-annealing be carried out at 625°C or higher.

Also, it is desirable that a precursor solution of the lead zirconate titanate containing a surplus of lead be spread on the lower electrode, on which the above-mentioned titanium oxide is deposited, based on a sol-gel method, that an amorphous layer of the lead zirconate titanate be formed by heating the precursor solution that has been spread, and that the amorphous layer be crystallized by annealing.

The above-mentioned oxide (in particular, titanium oxide) is preferably deposited at a film thickness of 0.01-10 nm.

### BRIEF DESCRIPTION OF THE DRAWINGS

Embodiments of the invention will now be further described, by way of example, with reference to the accompanying drawings in which:
FIG. 1 is an outlined cross-sectional view (A) and its plane view (B) (in which the upper electrode is omitted) schematically showing the PZT capacitor which is an embodiment of the present invention;
FIG. 2 is an outlined cross-sectional view showing the manufacturing sequence of the PZT capacitor;
FIG. 3 is a graph showing a comparison of the relationship (bipolar pulse voltage ±5 V) between the residual polarization density of the PZT capacitor due to the electrode material and the number of polarization inversions;
FIG. 4 is a hysteresis curve diagram of the dielectric polarization value of the PZT thin film;
FIG. 5 is an outlined cross-sectional view showing a comparison of the differences in structure due to the Pb concentration and annealing temperature of the PZT capacitor;
FIG. 6 is a sketch of a SEM image of the same PZT thin film formed on a TiOₓ nucleus-attached Ir electrode;
FIG. 7 is a graph showing the relationship between the residual polarization density and the number of polarization inversions due to the Pb concentration of the same PZT capacitor;
FIG. 8 is an I-V characteristic diagram of the PZT thin film formed on various electrodes;
FIG. 9 is a graph showing a comparison of the relationship between the residual polarization density and the number of polarization inversions due to the annealing temperature of the same PZT capacitor;
FIG. 10 is an X-ray diffraction spectral diagram of the PZT thin film of the same PZT capacitor;
FIG. 11 is a current-time characteristic diagram (A) and a current-voltage characteristic diagram (B) of the same PZT capacitor;
FIG. 12 is an outlined cross-sectional view schematically showing a comparative PZT capacitor;
FIG. 13 is an outlined cross-sectional view showing a semiconductor device (FRAM) in which the same PZT capacitor is assembled;
FIG. 14 is an outlined cross-sectional view showing a memory cell of a dynamic RAM in which the same PZT capacitor is assembled;
FIG. 15 is an enlarged cross-sectional view showing one process stage of the manufacturing method of the same memory cell;
FIG. 16 is an enlarged cross-sectional view showing another process stage of the manufacturing method of the same memory cell;
FIG. 17 is an enlarged cross-sectional view showing another process stage of the manufacturing method of the same memory cell;
FIG. 18 is an enlarged cross-sectional view showing another process stage of the manufacturing method of the same memory cell;
FIG. 19 is an enlarged cross-sectional view showing another process stage of the manufacturing method of the same memory cell;
FIG. 20 is an enlarged cross-sectional view showing another process stage of the manufacturing method of the same memory cell;
FIG. 21 is an outlined cross-sectional view of a PZT capacitor of a conventional example; and
FIG. 22 is an outlined cross section showing a semiconductor device (FRAM) in which the PZT capacitor of the conventional example is assembled.

### DESCRIPTION OF EMBODIMENTS

In the drawings, 8 represents a N⁺ type drain region, 9(WL) a word line, 10 a N⁺ type source region, 13 an Ir lower electrode, 14 a ferroelectric film (PZT thin film), 14a, 14b, 14c a PZT thin films (crystal grain layers), 15 an Ir upper electrode, 16 (BL) a bit line, 17 a silicon substrate, 20 a polysilicon layer, 30 a barrier layer, 31A, 31B a TiOₓ nucleus-attaching layers, 32a an amorphous PZT layer, 50a, 50b, 50c a crystal grains, 51a, 51b, 51c, 52A, 52B a grain boundaries, CAP a ferroelectric capacitor, TR a transfer gate, M-CEL a memory cell.

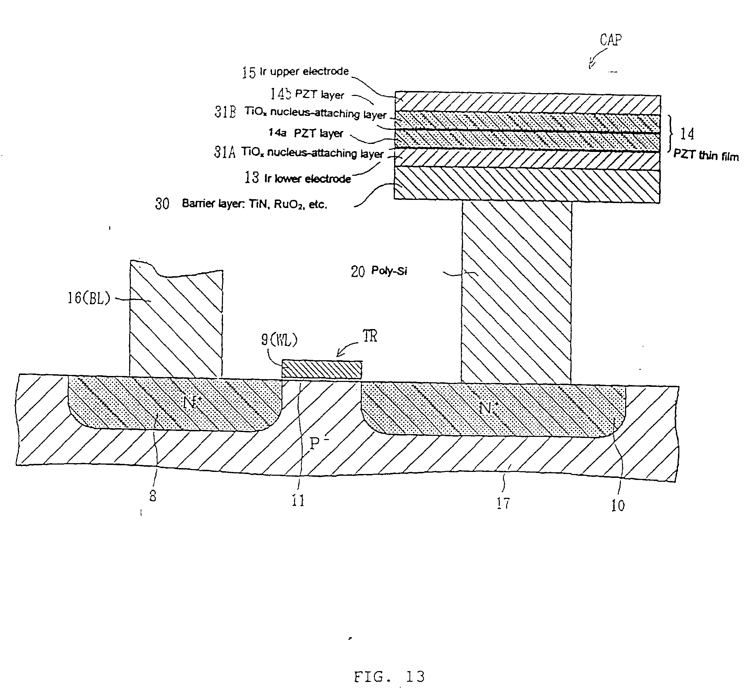

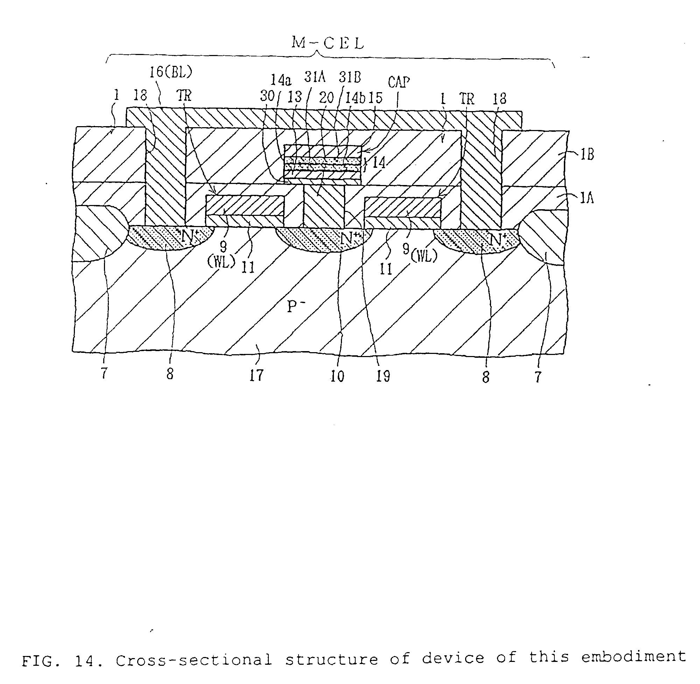

First in FIG. 13 and 14, an explanation will be given for a PZT ferroelectric capacitor CAP manufactured by a method embodying the invention and a CUB type memory cell of a semiconductor device (for example, a FRAM, which is a non-volatile storage element), in which this capacitor is assembled.

The PZT capacitor CAP of this embodiment, is shown as a stacked cell capacitor, and is constituted by: an iridium (Ir) layer 13 as a lower electrode; a PZT thin layer 14 on top of that composed of a laminate of PZT thin films 14a and 14b as an assembly of crystal grains formed by the sol-gel method, sputtering method, or CVD (Chemical Vapor Deposition) method by means of titanium oxide-deposited layers 31A and 31B; and an iridium layer (Ir) layer 15 provided as an upper electrode on the PZT thin film. Also, a barrier layer 30 of TiN, RuO₂ or the like is provided under the lower electrode 13 and connected to a silicon substrate by means of a polysilicon layer (plug) 20 deposited in a contact hole 19 of an insulation layer 1.

Therefore, as a first feature, iridium metal is used in the upper and lower electrodes of the capacitor CAP. These electrodes 3 and 5 may be respectively formed at a film thickness of 50-300 nm (for example, 100 nm) by an electron beam heating vacuum deposition method.

Also, as a second feature, the PZT thin films 14a and 14b, with the TiOₓ (titanium oxide) layers 31A and 31B nucleus-attached at a thickness of 0.01-10 nm (for example, 3 nm), respectively are formed at a thickness of approximately 150 nm (a total thickness of 300 nm for the PZT thin film 14) on the iridium lower electrode 13 and the lower layer PZT thin film 14a by the sol-gel method, furthermore, the composition in a sol state (or amorphous state) includes a surplus of Pb, and the Pb content is (1.02-1.50) times, at an atomic number ratio, the total amount of Zr and Ti. For example, the PZT thin film 14 may be formed at a film thickness of 300 nm with a composition of Pb:Zr:Ti = 1.1:0.5:0.5.

Then, as a third feature, these PZT thin films 14a and 14b are formed at a heating temperature of 625°C or higher (preferably, 650-750°C) by annealing at the time of crystallizing and/or by post-annealing after the crystallization, so that a structure transitional layer mainly composed of Pb precipitated on the surface is lost.

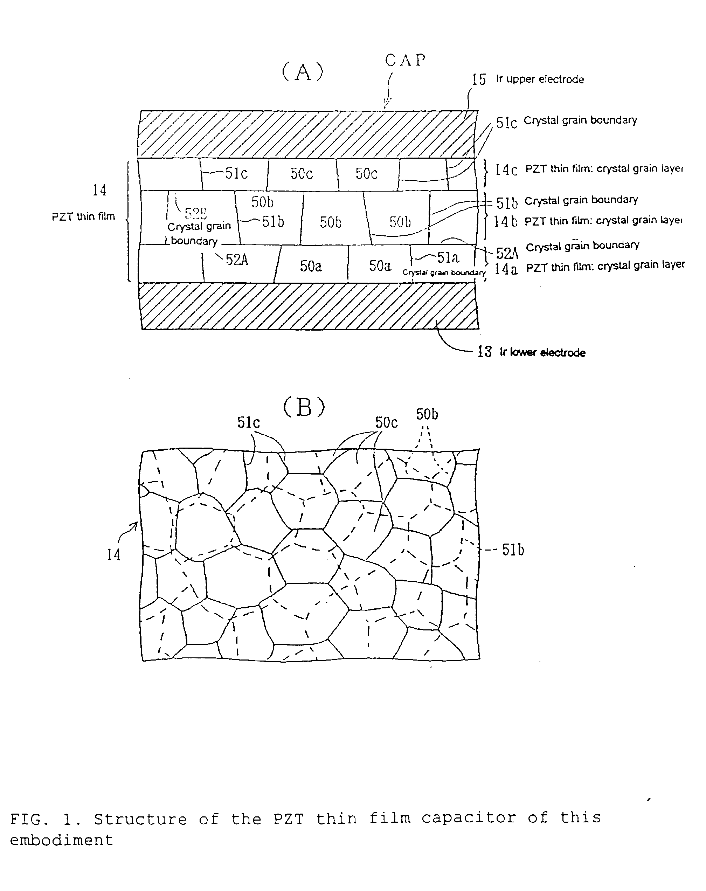

Furthermore, as a fourth feature, these PZT thin films, as shown in a schematic diagram of FIG. 1 (in the drawing, each PZT thin film is shown as a laminate of three layers 14a, 14b, and 14c, however it is also similar for the case of 2 layers or the case of 3 or more layers of FIG. 14), are composed of a polycrystal in which columnar PZT crystal grains 50a, 50b, and 50c are assembled by means of grain boundaries 51a, 51b, and 51c, and the positions of the above-mentioned grain boundaries 51a, 51b, and 51c are shifted with regard to each other between the PZT thin films 14a and 14b and between 14b and 14c. Also, continuous grain boundaries 52A, 52B nearly parallel to the Ir lower electrode 13 exist between the PZT thin films 14a and 14b and between 14b and 14c.

The grain size in each of the above-mentioned PZT thin films is 20-100 nm, and the thickness of each film is preferably 100-150 nm. Also, since the above-mentioned TiOₓ (titanium oxide) layer at each interface is very thin and is easily lost when the PZT is crystallized, it is not shown in FIG. 1.

In the memory cell of a FRAM having a PZT capacitor CAP, as shown in FIG. 14, for example, an element region divided by a field oxide film 7 is formed on one principal face of a P⁻ type silicon substrate 17, and a memory cell M-CEL consisting of: a transfer gate TR consisting of a MOS transistor, and the capacitor CAP, is provided here.

In the transfer gate TR, for example, a N⁺ type source region 10 and a N⁺ type drain region 8 are respectively formed by impurity diffusion, and a word line 9 (WL) is provided between these two regions by means of a gate oxide film 11. A bit line 16 (BL) is connected to the source region 10 by means of a contact hole 18 of the insulation layer 1 of, for example, SiO₂.

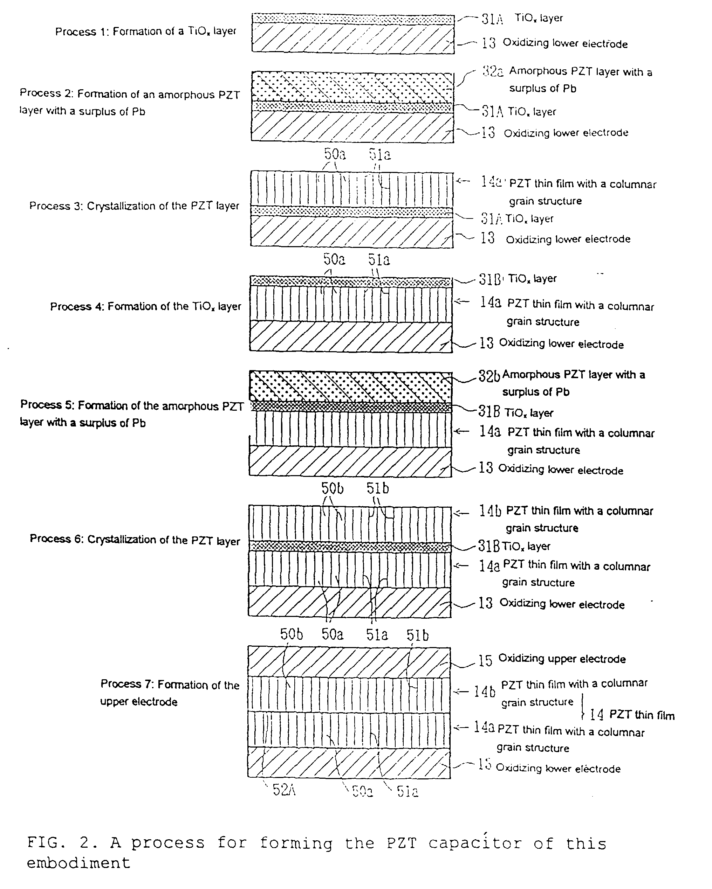

Next, the basic manufacturing method of the above-mentioned ferroelectric capacitor CAP will be explained in regard to FIG. 2.

First, in process 1, an oxidizing lower electrode made of an oxidizing metal, for example, Ir (iridium) thin film 13 (lower electrode), is formed at a thickness of 100 nm on the above-mentioned barrier layer by sputtering or by an electron beam heating vapor deposition method. Then, a TiOₓ 31A with a film thickness of 3 nm is deposited on the lower electrode 13 by a RF sputtering method using a TiO₂ target. The TiOₓ 31A acts as a nucleus for the PZT crystal.

Next, in process 2, an amorphous PZT thin film 32a with a film thickness of 150 nm is formed by the sol-gel method. The formation temperature of the amorphous thin film was 480°C (10 min, in the air). The raw material (PZT precursor) solution of the sol-gel method may be Pb(CH₃COO)₂·3H₂O, Ti{(CH₃)₂CHO}₄, Zr{CH₃(CH₂)₂CH₂O}₄, and CH₃OC₂H₄OH of NH(CH₂CH₂OH)₂ solutions and this is spread and dried. The composition of the raw material solution (or amorphous thin film) includes a surplus of Pb and may be at an atomic number ratio of Pb:Zr:Ti = 1.1:0.5:0.5.

Next, in process 3, the amorphous PZT thin film 32a formed in process 2 is annealed (sintered) at 625-750°C (in particular, 650°C or higher) for 10 min in an oxygen atmosphere or in the air. The PZT is crystallized by the sintering processing, so that PZT ferroelectric thin film 14a with a Perovskite structure with a thickness of 150 nm is formed. In the crystallization, TiOₓ 31A at the interface of the amorphous PZT 32a and IR 13 increases the nuclear density of the PZT, so that thin film 14a with a dense structure is formed.

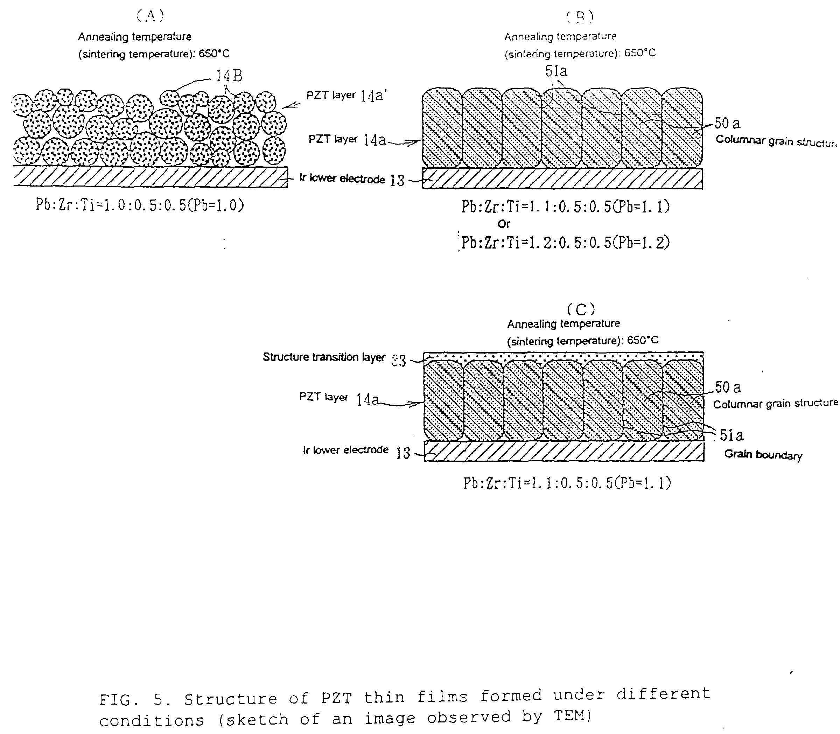

Then, this PZT thin film 14a, as will be mentioned later in FIG. 5, grows as a polycrystalline layer in which columnar crystal grains 50a are assembled by means of crystal grain boundaries 51a (see FIG. 1), and the structure transitional layer (a precipitate mainly composed of Pb due to the above-mentioned surplus of Pb) precipitated on the surface of the PZT thin film 14a is lost due to the above-mentioned annealing temperature. At this moment, since the above-mentioned TiOₓ layer 31A is included in the PZT thin film 14a, it is not shown in the following processes.

Next, in process 4, a TiOₓ 31B with a film thickness of 3 nm is deposited on PZT thin film 14a using the RF sputtering method using a TiO₂ target. The TiOₓ 31B also acts a nucleus of the PZT crystal.

Next, in process 5, an amorphous PZT thin film 32b with a film thickness of 150 nm is formed by the sol-gel method. The formation temperature of the amorphous thin film was 480°C (10 min, in the air). The raw material (PZT precursor) solution of the sol-gel method may be Pb(CH₃COO)₂·3H₂O, Ti{(CH₃)₂CHO}₄, Zr{CH₃(CH₂)₂CH₂O}₄, and CH₃OC₂H₄OH of NH(CH₂CH₂OH)₂ solutions and this is spread and dried. The composition of the raw material solution (or amorphous thin film) includes a surplus of Pb and may be at an atomic number ratio of Pb:Zr:Ti = 1.1:0.5:0.5.

Next, in process 6, the amorphous PZT thin film 32a formed in process 5 is annealed (sintered) at 625-750°C (in particular, 650°C or higher) for 10 min in an oxygen atmosphere or in the air. The PZT is crystallized by the sintering processing, so that PZT ferroelectric thin film 14b with a Perovskite structure with a thickness of 150 nm is formed. In the crystallization, TiOₓ 31B at the interface of the amorphous PZT 32b and the PZT crystal 14a increases the nuclear density of PZT, so that thin film 14b with a dense structure is formed.

Then, PZT thin film 14b, as with the above-mentioned PZT thin film 14a, grows as a polycrystalline layer in which columnar crystal grains 50b are assembled by means of crystal grain boundaries 51b, and the structure transition layer (a precipitate mainly composed of Pb due to the above-mentioned excessive amount of Pb) precipitated on the surface of the PZT thin film 14b is lost due to the above-mentioned annealing temperature. At this moment, since the above-mentioned TiOₓ layer 31B is included in the PZT thin film 14b, it is not shown in the following processes.

Next, in process 7, an oxidizing upper electrode made of an oxidizing metal, for example, the Ir (iridium) upper electrode 15, is formed at a thickness of 100 nm on PZT thin film 14b of Perovskite crystals formed in process 6 by sputtering or electron beam heating vapor deposition method. In this way, the PZT capacitor CAP is manufactured.

In manufacturing the PZT capacitor CAP as mentioned above, it is very important with respect to the capacitor performance (in particular, prevention of dielectric fatigue and stabilization of resistivity) mainly to have the above-mentioned 4 features.

### (1) First, the electrode substance will be explained.

In general, as the electrode of the PZT capacitor, a substance such as Pt (however, sometimes Au is used only as the upper electrode), which does not oxidize is used. In this regard, the present inventors succeeded in relieving the dielectric fatigue by using a metal such as metallic Ir, which is easily oxidized, as both lower and upper electrodes 13 and 15.

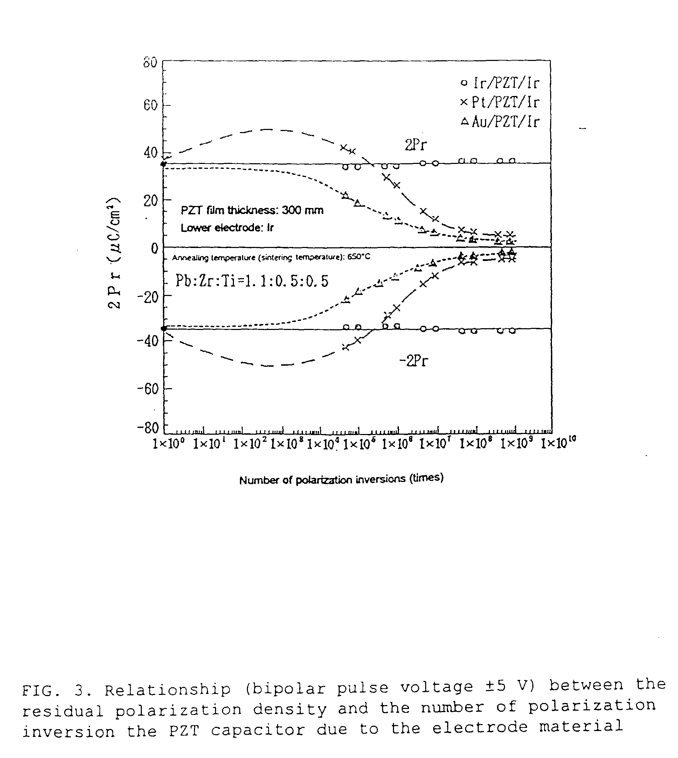

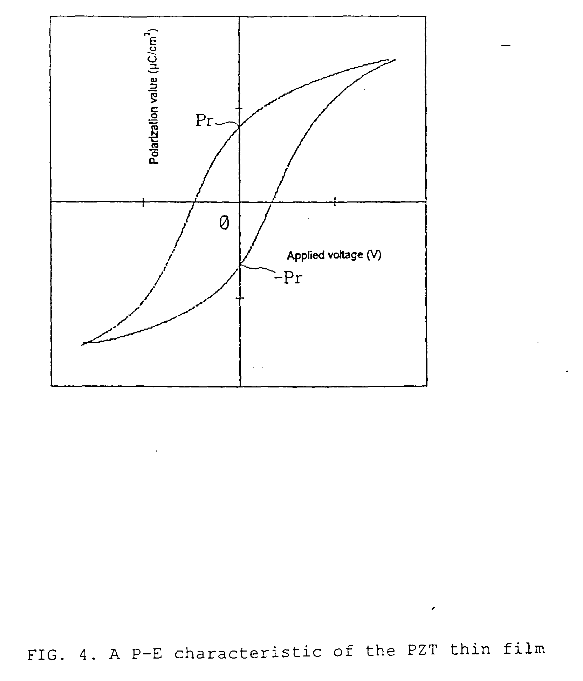

FIG. 3 shows a comparison of the dielectric fatigue characteristic of PZT capacitors with Au/PZT/Ir, Pt/PZT/Ir, and Ir/PZT/Ir structures in which the lower electrode is made of Ir. Also, FIG. 4 shows a hysteresis curve of the residual polarization density for the PZT thin film.

From FIG. 3, it is observed that in the capacitor using Au in the upper electrode, the residual polarization density is reduced to nearly zero by an inversion of 10⁶ times or more, and that in the capacitor using Pt in the upper electrode, the fatigue characteristic is slightly improved, however the polarization characteristic is rapidly lowered for an inversion of 2 x 10⁶ times or more. However, when Ir is used in the upper electrode, the reduction in the polarization characteristic is not seen up to an inversion of 2 x 10⁹ times.

Thus, it is apparent that the dielectric fatigue characteristic also depends greatly on the electrode substance, and that the residual dielectric polarization density (Pr) of the capacitor of this embodiment using Ir in both upper and lower electrodes 13 and 15, compared with others, is stable at the time of polarization inversion and is excellent. It is considered that this is due to oxidation resistance and the like of the Ir metal.

### (2) Next, the control of the crystallization direction of the PZT is mentioned.

As mentioned above, if the amorphous PZTs 32a and 32b are deposited on the (Ti-seeding) Ir lower electrode 13 and the PZT layer 14a on which the titanium oxides 31A and 31B are deposited, and heated to crystallization temperature or higher, the nucleus of the PZT crystallization is formed in the vicinity of the titanium oxides 31A and 31B at the interfaces of both layers 32a-13 and 32b-14a, and the crystallization advanced in the thickness direction. By means of this crystallization process the columnar grain structures 50a and 50b are formed as shown in FIG. 5(C) and the surplus lead, etc., is pushed up to the surface. For example, for the PZT layer 14a (also similarly the PZT layer 14b), the structure transition layer 33 mainly composed of Pb is formed on the surface.

However, this type of crystallization due to a nonuniform nucleus generation is caused only when a PZT precursor solution containing a surplus of lead is used. Here, 3 solution compositions are used, at an atomic number ratio of: Pb:Zr:Ti = 1.0:0.5:0.5, 1.1:0.5:0.5, and 1.2:0.5:0.5. A fine structure of the PZT thin film formed on Ir lower electrode 13, Ti-seeded by providing the TiOₓ nucleus-attaching layer, is shown as a transmission electron microscope TEM sketch in FIG. 5 (however, the TiOₓ nucleus-attaching layer was omitted in the drawing for the sake of simplicity), and agglomerated, columnar, columnar grain structures are respectively obtained according to the above-mentioned composition.

In other words, when the Pb concentration of the precursor solution (or amorphous PZT) is low (Pb = 1.0), as shown in FIG. 5(A), a PZT thin film 14a' is formed only by an assembly of the agglomerated grains 14B; however if there is a surplus Pb concentration at the same sintering temperature (650°C) (Pb > 1.0, in particular Pb = 1.1 or Pb = 1.2, which fulfills the condition Pb ≥ 1.02), the columnar grain structure 50a is obtained.

An appropriate composition of the PZT precursor solution is Pb = 1.02-1.50 (to Zr + Ti = 1.0) (however, the ratio of Ti/Zr is arbitrary). If the Pb concentration is too low, the above-mentioned columnar structure (the control of the PZT crystallization direction) is difficult to realize, and if on the other hand the Pb concentration is too high, the amount of said structure transition layer precipitated on the surface increases, so that it is difficult to eliminate it.

Also, at low sintering temperature (600°C), as shown in FIG. 5(C), the structure transition layer 33 is easily generated, whereas the structure transition layer 33 is eliminated by controlling the sintering temperature to 625°C or higher, for example, 650°C. However, if the sintering temperature is too high, since it is difficult for the PZT crystal to be generated, the temperature is preferably 750°C or lower.

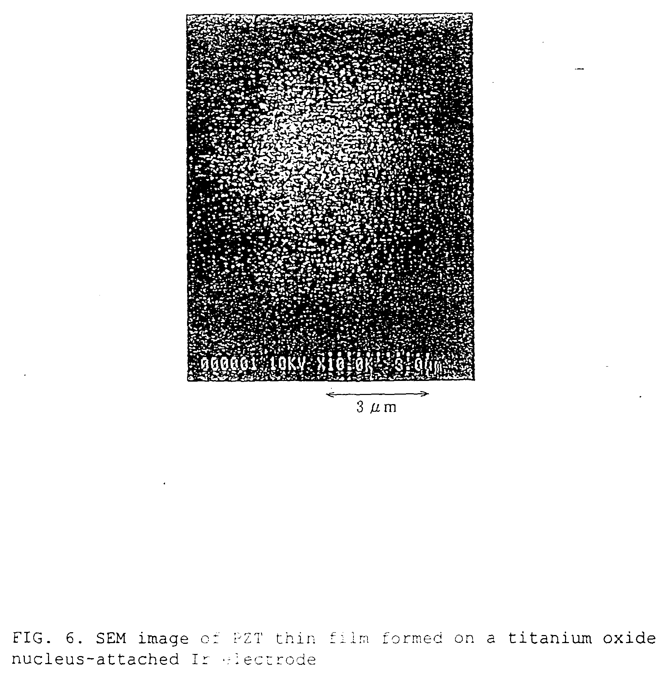

Also, FIG. 6 shows a SEM (scanning electron microscope) image of the surface of PZT thin film 14a (the same for 14b) formed on the Ir lower electrode to which the titanium oxide nucleus is attached, and it is seen that the PZT is fine grained and dense with a grain diameter of 100 nm or less.

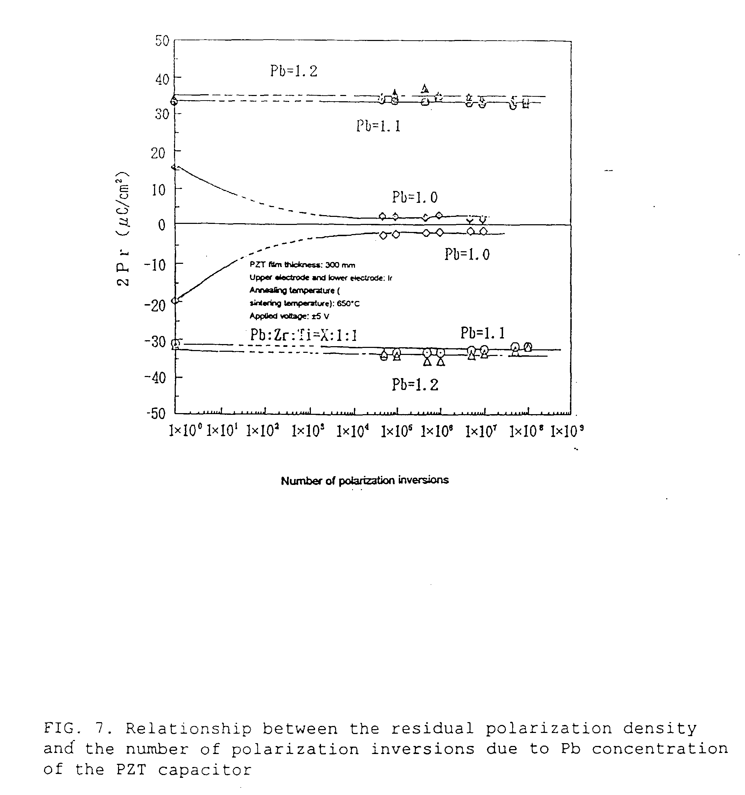

FIG. 7 shows the dependency of the dielectric fatigue characteristic on the composition for each PZT capacitor manufactured by vapor-depositing the Ir upper electrode on a PZT thin film obtained from the above-mentioned raw material with each Pb concentration.

Based on this, the residual polarization density of the PZT capacitor with Pb = 1.0 is reduced to nearly zero by and inversion of 10⁷ times. On the contrary, in the PZT capacitor with Pb = 1.1 and 1.2, a reduction of the residual polarization density is not seen, even for an inversion of 10⁸ times.

Thus, the fatigue characteristic is also greatly improved by using a precursor solution containing Ti-seeding and a surplus of Pb, which causes crystal growth in one direction.

Next, as mentioned above, for a PZT thin film formed on the Ir lower electrode to which TiOₓ is nucleus-attached and a PZT thin film formed on the Pt/TiN electrode to which TiOₓ is not nucleus-attached, the electrical characteristics are compared.

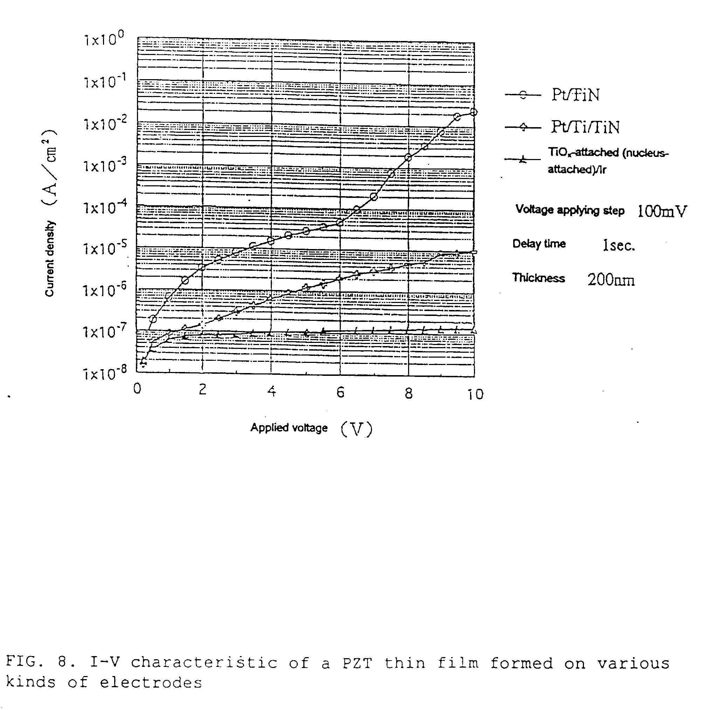

FIG. 8 shows an I-V characteristic, and according to the data, it is shown that the leakage current value of the PZT thin film formed on the Pt/TiN lower electrode is markedly increased with an increase in the applied voltage. However, when using the Ir lower electrode to which TiOₓ is nucleus-attached, the leakage current value is approximately 1 x 10⁻⁷ A/cm², and an excellent I-V characteristic is shown.

### (3) Next, the sintering (annealing) temperature of the PZT is mentioned.

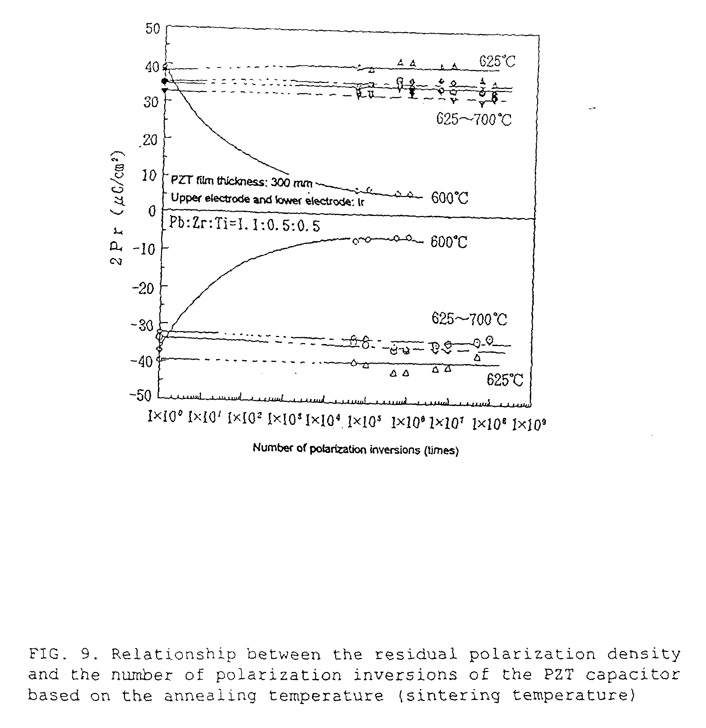

The relationship between the annealing temperature of the PZT and the dielectric fatigue characteristic is shown in FIG. 9.

According to this, in the PZT formed at 600°C, the residual polarization density is reduced to nearly zero by a polarization inversion of 10⁸ times. However, the polarization characteristic of the capacitor formed at 625°C is markedly improved, and in a sample formed at 625-700°C, the reduction of the residual polarization density is seldom seen, even with an inversion of 10⁸ times. The reason for this is considered to be that the structure transition layer 33 of a surplus of Pb formed on the surface is lost at 625°C or higher, so the fatigue characteristic is improved.

### (4) Furthermore, the lamination of the PZT crystal grain layer will be explained.

As is clearly seen from the aforementioned, a PZT capacitor in which dielectric fatigue does not occur can be formed by (1) using Ir as the electrode substance, (2) using a Ti-seeding method and a solution with a surplus of Pb, and (3) crystallizing PZT at or higher than the temperature at which the surface structure transition layer is lost.

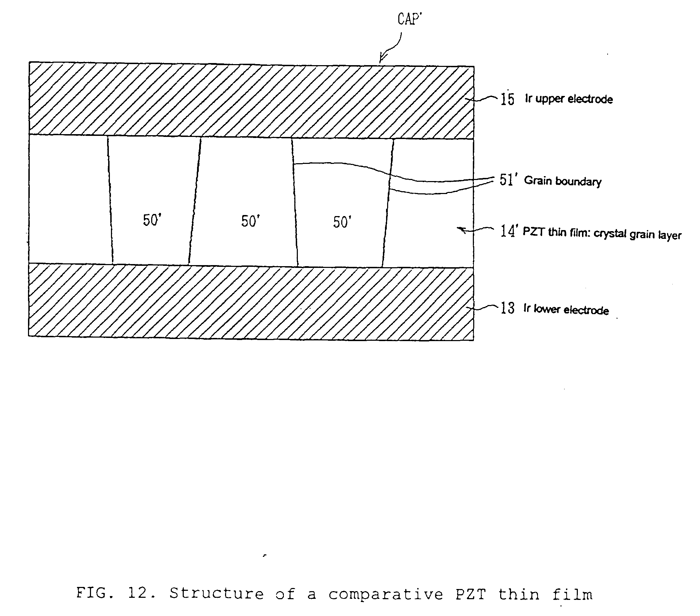

FIG. 12 schematically shows a cross-sectional structure of a PZT capacitor CAP' in which the PZT crystal grain layer is formed as a single layer based on the above-mentioned points (1)-(3). In the capacitor CAP', for the above-mentioned reasons, a PZT thin film 14' with a thickness of 300 nm, in which columnar PZT crystal grains 50' are collected by means of a grain boundary, is formed between the upper and lower Ir electrodes 13 and 15.

Therefore, dielectric fatigue is not seen, however, since grain boundary 51' exists across the thickness direction of the thin film 14' and a grain boundary parallel with the electrode 13 does not exist in the crystal grain layer with a columnar structure, the current easily flows along the grain boundary 51' extending in the thickness direction, and leakage current increases. At the same time, the deterioration in resistivity, which is considered to results from oxygen hole diffusion along the grain boundary 51', easily occurs. For example, a leakage current of 10⁻⁴ µA/cm² or more has been confirmed.

On the contrary, in the PZT capacitor CAP of the present embodiment, as shown in FIG. 1, the PZT thin film 14 is composed of a laminate of multiple PZT crystal grain layers 14a, 14b, and 14c each with a film thickness of approximately 100 mm formed based on the above-mentioned points (1)-(3), and in each crystal grain layer, columnar PZT crystal grains 50a, 50b, and 50c with a grain size of 20-100 nm are assembled by means of the grain boundaries 51a, 51b, and 51c. Between the PZT thin films 14a and 14b and the films 14b and 14c, the positions of the above-mentioned grain boundaries 51a, 51b, and 51c are shifted with respect to one another, and between the PZT thin films 14a-14b and 14b-14c, continuous grain boundaries 52A and 52B exist virtually parallel to the Ir lower electrode 13.

Therefore, in the capacitor CAP, since the grain boundaries 52A and 52B are intentionally introduced at arbitrary places parallel with the electrode 13, while the crystal grains 50a, 50b, and 50c of the PZT of each PZT thin film 14a, 14b, and 14c have a columnar structure, and the grain boundaries 51a, 51b, and 51c exist in the thickness direction, these grain boundaries 52A and 52B become obstacles to conductive electrons, a cause of leakage current, and to oxygen hole diffusion, a cause of resistivity deterioration. In other words, since the electrons and the oxygen holes moved or diffused along grain boundaries 51a, etc., in the thickness direction of each PZT thin film are blocked by grain boundaries 52A and 52B parallel with the electrode 13, the movement and diffusion advance no more.

Thus, in the capacitor CAP, leakage current and resistivity deterioration as well as the dielectric fatigue are not generated (or are considerably reduced).

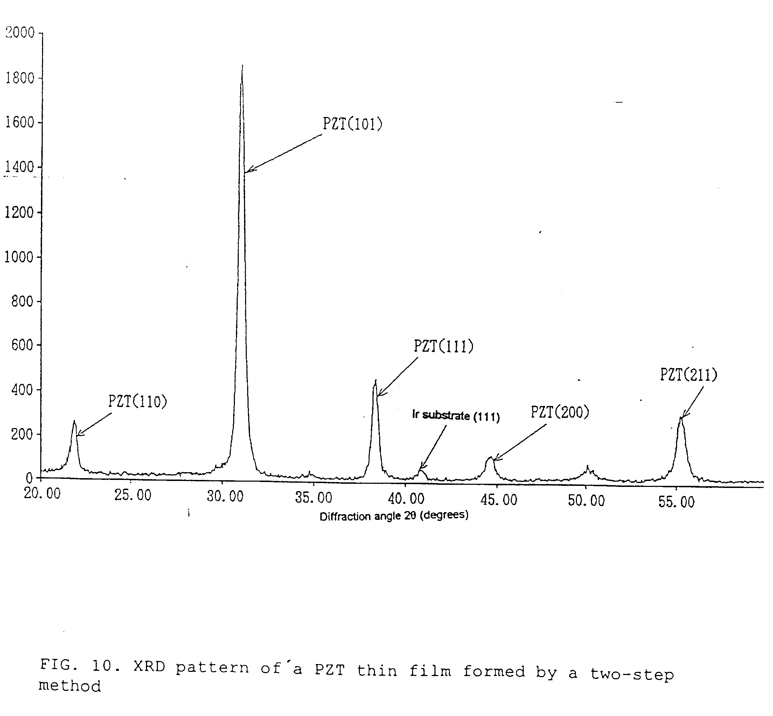

FIG. 10 shows an XRD (X-ray diffraction spectrum) of the PZT thin film of the PZT capacitor (in which the number of laminations of the PZT crystal grain layer was set at 2: two-step method) embodying the invention. According to this experimetal result a diffraction peak such as (101) intrinsic to the Perovskite crystal is seen, and it is seen that the PZT thin film made of a crystal with the Perovskite structure is formed. This is also similar to the PZT thin film of FIG. 1 in which the PZT crystal grain layer is composed of 3 layers.

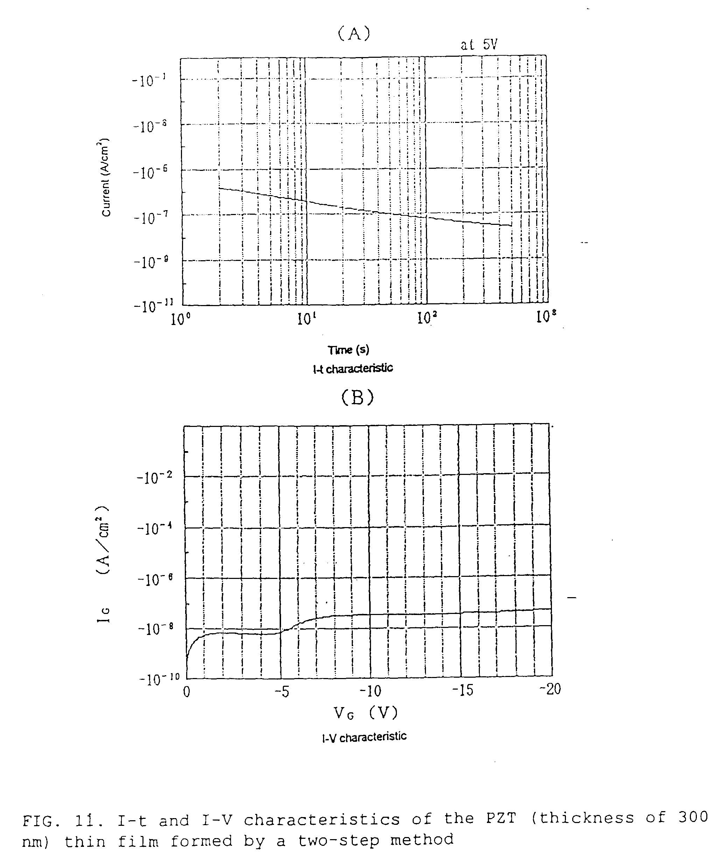

Also, FIG. 11 shows the results of measuring the leakage current characteristic (A) and the current-voltage characteristic (B) of the PZT thin film formed by the two-step method. According to this experimental result in the PZT thin film formed based on the present invention, the leakage current is 10⁻⁸ A/cm² or less and is markedly decreased, and it can be understood that the I-V characteristic, since the leakage current is very small, is also stable.

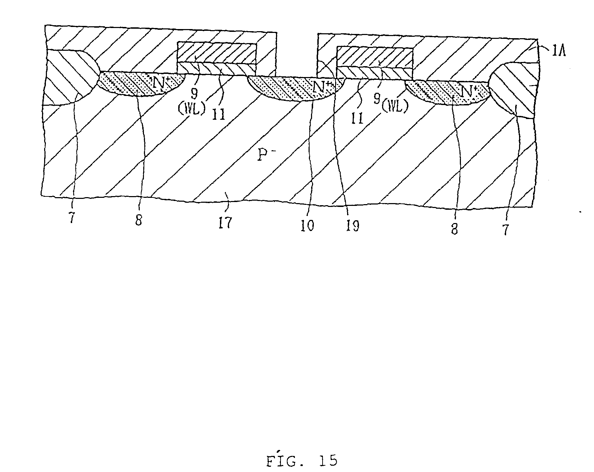

Next, the manufacturing method of a semiconductor device in which the PZT capacitor of the present embodiment is assembled--for example, a FRAM memory cell (for example, a stack type), which is a non-volatile memory--is explained with respect to FIGS. 15-20.

First, as shown in FIG. 15, the field oxide film 7 is formed on a P⁻ type silicon substrate (wafer) by a selective oxidation method, and the gate oxide film and the polysilicon word line 9 (WL) by the thermal oxidation method and by the chemical vapor deposition method respectively are formed. Furthermore, the N⁺ type source region 10 and the drain region 8 are respectively formed by thermal diffusion of an N-type impurity such as As.

Then, for the SiO₂ insulation layer 1A deposited on the entire surface by the chemical vapor deposition method, a contract hole 19 is formed on the source region 10 by photolithography.

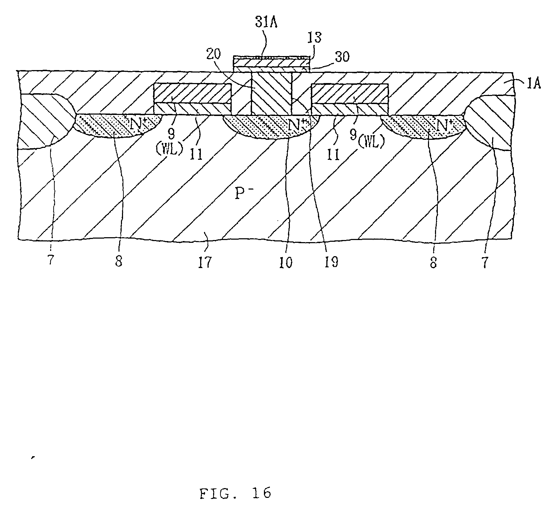

Next, as shown in FIG. 16, polysilicon layer 20 is deposited in the contact hole 19 so that it contacts the source region 10, and on this the TiN barrier layer 30 and the Ir lower electrode 13 are formed, and the TiOₓ layer 31A is formed by sputtering; this structure can be formed by means of patterning by photolithography the poly-Si layer, TiN layer, Ir layer, and TiOₓ layer deposited on the entire surface by.

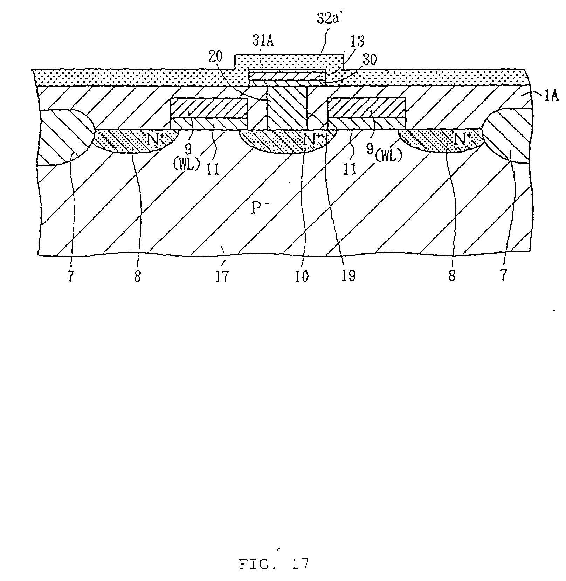

Next, as shown in FIG. 17, the above-mentioned sol-gel raw material solution 32a' with a surplus of Pb is spread on the entire surface, including the lower electrode 13 and the TiOₓ layer 31 by a spin-coating method or a dip-coating method.

Next, the wafer on which the raw material solution 32a' is spread is heated for 3 min, for example, at a prescribed temperature (100-300°C, for example, 170°C) and the solution that has been spread is dried, so that a dried gel film is formed.

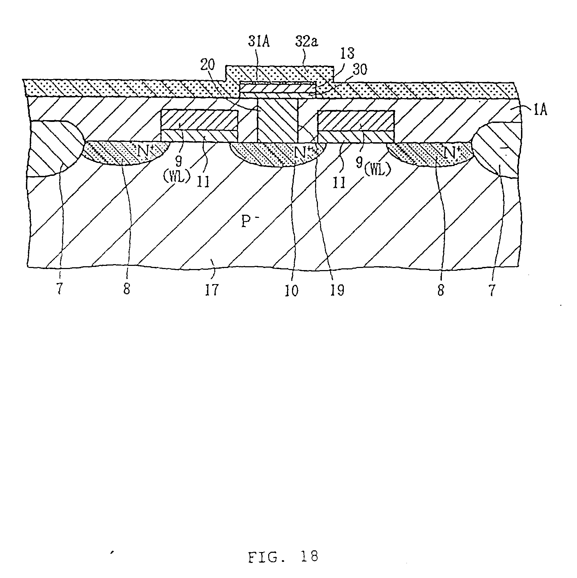

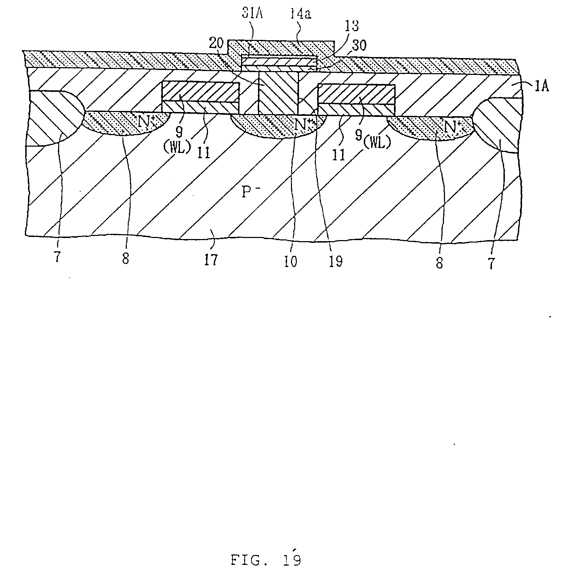

Next, the dried wafer is changed to the amorphous state 32a as shown in FIG. 18 by processing at 480°C. Then, the above-mentioned columnar structure of Perovskite crystal is generated in air and sintered for 10 min, for example, at a temperature (625°C or higher, for example, 650°C) at which the structure transition layer 33 of the surface is lost, so that the ferroelectric film 14a shown in FIG. 19, is formed on the entire surface.

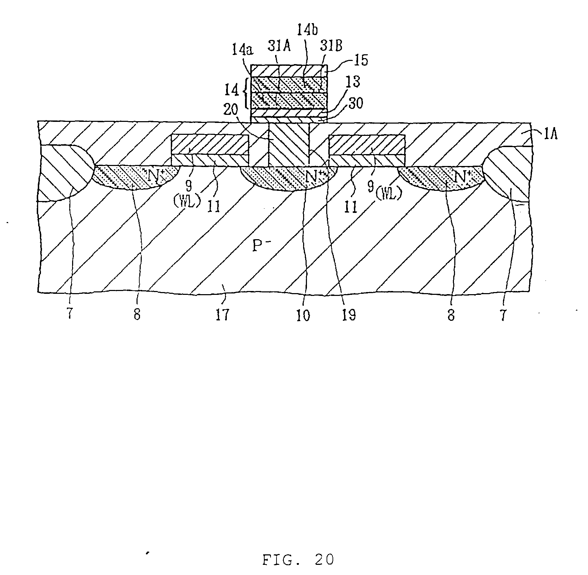

Next, just as in the above, TiOₓ layer 31B, and the ferroelectric film 14b, with a columnar structure, which is a Perovskite crystal and is formed from the sol-gel raw material solution with a surplus of Pb are formed on ferroelectric film 14a by repeating the processes of FIG. 16-19. The unnecessary portion of these ferroelectric thin films 14 is removed by the dry-etching method or the like, and as shown in FIG. 20, PZT ferroelectric film 14 is formed in a prescribed pattern on lower electrode 13.

Next, iridium is deposited by sputtering, and the upper electrode 15 made of iridium is formed in a prescribed pattern at the portion in contact with the ferroelectric thin film 14 by means of photolithography.

Furthermore, the interlayer insulating film 1B, contact hole 18, and bit line 16 (BL) shown in FIG. 14 are respectively formed by a known method, and as shown in FIG. 14 the memory cell M-CEL is manufactured.

In the above, an embodiment of the present invention has been explained; however the above-mentioned embodiment can be further modified based on the technical concept of the present invention.

For example, in addition to Ir, as the electrode material, Pd, Ru, W, Ti, Cr, and Ni can be substituted in the lower and upper electrodes. Any of these materials is easily oxidized (easily changed to an oxide). These metals may be used alone or in combination with multiple kinds, or by mixing with other metals.

Also, as the nucleus attaching material deposited on the surface of the lower electrode or the PZT crystal grain layer, a TiO₂ or other TiOₓ has been used; however, starting with Ti, other than Ti, an oxide of one or more kinds of element(s) of Zr, Pb, La, Zn, Nb, Fe can be deposited on the electrode as long as it is a metal which is easily changed to an oxide at normal temperature.

Here, of the above-mentioned usable metals, La, Zn, Nb, and Fe are elements which can be added to the ferroelectric film. Ti, Zr, and Pb are main components of the PZT.

In forming the oxide of the above-mentioned metals, in addition to the sputtering method, a method which deposits Ti, Zr, Pb, Sr, Ba, La, Zn, Nb, and Fe by the electron beam heating vapor deposition method under high vacuum, etc., and subsequently naturally oxidizes them in an oxygen atmosphere (for example, in air) can also be adopted.

In this case, in particular, since Ti is a very active substance, the deposit formed by the electron beam heating vapor deposition method is oxidized by residual oxygen in the vapor deposition chamber. Thus, a strong oxidation treatment is not required. The film thickness of the TiOₓ is between 0.01-10 nm, especially 1-5 nm is preferable. As the deposition method of the oxide, sputtering method, CVD method, and vapor deposition method can be mentioned.

As a method for forming the amorphous PZT, the sol-gel method has been used in the above-mentioned embodiment. However, the amorphous PZT also can be formed by means of the sputtering method and the CVD method by setting the substrate temperature to 500°C or lower. Therefore, if an amorphous PZT thin film with an excessive Pb amount is formed by these methods and the above-mentioned processes are applied, effects similar to the above-mentioned effects are obtained.

Also, in eliminating the above-mentioned surface structure transition layer, the crystallization temperature of PZT is preferably 625°C or higher, however such a temperature condition may also be adopted at the time of post-annealing after the PZT crystallization. In other words, the above-mentioned structure transition layer also can be removed by setting the post-annealing temperature to 625°C or higher.

As the material which can be used for the ferroelectric film, in addition to the above-mentioned PZT, a PZT to which Nb, Zr, Fe, etc., are added to the PZT, PLT ((Pb, La)ₓ(Ti, Zr)₁₋ₓO₃), etc., may also be adopted.

Also, the above-mentioned nucleus attachment, formation of the amorphous PZT, PZT crystallization, and processes which repeat these can be collectively continuously performed using a sputtering apparatus or CVD apparatus. The number of laminations of the PZT crystal grain layer may be changed in the range in which film formability and productivity are not damaged, and two layers, three layers, or more are possible.

The ferroelectric film of the present invention can be applied to a device having a capacitor (stacked capacitor) with a Ir/PZT/Ir/barrier layer/poly-Si structure shown in FIG. 1, for example; however, without being limited to this, it also can be applied to a capacitor with a structure in which the above-mentioned stacked capacitor is provided on a SiO₂ film and the lower electrode of the capacitor is connected to the source region of the transfer gate by extension, or a capacitor with a structure in which the capacitor is assembled into a so-called trench (groove), instead of the stack type. Also, the present invention can be applied to uses other than a FRAM. Also, the present invention can be applied to a COB (Cell Over Bitline) type memory cell.

According to the ferroelectric capacitor embodying the invention, as mentioned above, it has a first electrode made of a metal such as iridium which is easily oxidized, a ferroelectric film such as PZT thin film on this first electrode, and a second electrode such as an iridium electrode on the ferroelectric film, and multiple crystal grain layers constituted by assembling crystal grains by means of the grain boundaries are laminated by means of the grain boundaries along the surface of the above-mentioned first electrode, so that the above-mentioned ferroelectric film is formed, therefore although the above-mentioned crystal grain layer is an assembly of crystal grains by means of the grain boundaries, since the grain boundaries between the multiple crystal grain layers and existing along (preferably, nearly parallel with) the surface of the first electrode become obstacles to conductive electrons, a cause of leakage current, and to diffusion of oxygen holes, a cause of resistivity deterioration, penetration of the conductive electrons and oxygen holes from the grain boundaries of the crystal grain boundary of the lower layer into the grain boundaries of the crystal grain layer of the upper layer can be effectively suppressed. Therefore, leakage current and resistivity deterioration can be sufficiently prevented, so that these characteristics are markedly improved.

## Claims

1. A capacitor comprising;
a first electrode formed from a metal that is easily oxidised;
a ferroelectric film formed substantially over the first electrode;
a second electrode formed on ferroelectric film;
and wherein multiple crystal grain layers are constituted by assembling crystal grains by means of grain boundaries along a surface of the first electrode such that said ferroelectric film is formed.

2. The capacitor as claimed in Claim 1, wherein grain boundaries extending substantially from the first electrode to the second electrode in each of the multiple crystal grain layers occur at different positions between the multiple crystal grain layers such that grain boundaries between the multiple crystal grain layers exist continuously along the surface of the first electrode.

3. The capacitor as claimed in Claim 1 or Claim 2, wherein the first and second electrodes are formed from iridium and the ferroelectric film is formed from lead zirconate titanate.

4. A memory device comprising one or more capacitors as claimed in any of Claims 1 to 3.

5. A method for manufacturing a capacitor comprising;
forming a first electrode from a metal that is easily oxidised;
forming a ferroelectric film substantially over the first electrode;
forming a second electrode on the ferroelectric film;
and wherein the step of forming the ferroelectric film comprises constituting multiple crystal grain layers by assembling crystal grains by means of grain boundaries along a surface of the first electrode.

6. The method as claimed in Claim 5, wherein the step of forming the ferroelectric film comprises;
depositing a first oxide layer comprising at least one element of the constituent elements of the ferroelectric film;
forming a first ferroelectric material layer comprising a surplus of a constituent element of the ferroelectric film on the oxide layer;
forming a lower crystal grain layer by heating at a temperature at which surface precipitates mainly composed of said constituent element are substantially lost;
depositing a second oxide layer of at least one element of the constituent elements of the ferroelectric film on the lower crystal grain layer;
forming a second ferroelectric film layer containing a surplus of a constituent element of the ferroelectric film on the lower crystal grain layer on which the second oxide layer is deposited;
forming an upper crystal grain layer by heating at a temperature at which surface precipitates mainly composed of the constituent element are substantially lost.

7. The method as claimed in Claim 6, wherein the steps of depositing the second oxide layer, forming the second ferroelectric film layer, and forming an upper crystal grain layer are repeated.

8. The method as claimed in any of Claims 5 to 7, further comprising;
forming the ferroelectric film from lead zirconate titanate.

9. The method as claimed in any of Claims 6 to 8, wherein the steps of depositing the first oxide layer and forming the second ferroelectric film layer comprise depositing titanium oxide.

10. The method as claimed in any of Claims 6 to 9, wherein the steps of forming the first and second ferroelectric layers comprise forming an amorphous layer of lead zirconate titanate containing a surplus of lead.

11. The method as claimed in any of Claims 6 to 10, wherein the steps of forming the lower and upper crystal grain layer comprise annealing said capacitor at a temperature at which surface precipitates substantially composed of surplus lead are substantially lost; and
post-annealing said crystal grain layer.

12. The method as claimed in Claim 10 or Claim 11, wherein the step of forming an amorphous layer of lead zirconate titanate containing a surplus of lead comprises forming a layer in which the lead content of the amorphous layer is 1.02 - 1.50 times, at an atomic ratio, the total amount zirconium and titanium, and performing the annealing and post-annealing at 625 Celsius or higher.

13. The method as claimed in any of Claims 8 to 12 further comprising;
forming a titanium oxide on the lower electrode;
forming the ferroelectric film using a sol-gel process in which a precursor solution of lead zirconate titanate is distributed on the lower electrode;
forming an amorphous layer of lead zirconate titanate by heating the precursor solution; and
crystallising the amorphous layer by annealing.

14. The method as claimed in any of Claims 5 to 13, wherein the steps of forming the first and second oxide layers comprises depositing an oxide to a thickness of 0.01 - 10 nm.

15. A method of fabricating a memory cell comprising at least one capacitor is formed according to the method of any of Claims 5 to 14.
